# EUROPEAN PATENT SPECIFICATION

(11) **EP 0 329 569 B1**
(45) Date of publication and mention of the grant of the patent: **05.07.1995**
(21) Application number: 89400463.9
(22) Date of filing: 17.02.1989
(51) Int. Cl.: H01L 29/41, H01L 27/10

(54) **Semiconductor device with a thin insulating film**
Halbleiteranordnung mit einer dünnen isolierenden Schicht
Dispositif semi-conducteur ayant une mince couche isolante

(30) Priority: 17.02.1988 JP 34346/88
(43) Date of publication of application: 23.08.1989
(73) Proprietor: FUJITSU LIMITED, Kawasaki-shi, Kanagawa 211 (JP)
(72) Inventor: Ema, Taiji, Kawasaki-shi Kanagawa 213 (JP); Shirai, Kazunari, Hodogaya-ku Yokohama-shi Kanagawa 240 (JP)
(74) Representative: Joly, Jean-Jacques

(56) References cited:
- EP-A- 0 012 863
- FR-A- 2 133 893
- US-A- 3 897 282

## Description

### BACKGROUND OF THE INVENTION

### 1. Field of the Invention

The present invention relates to a semiconductor device, and more particularly, to a polycrystalline silicon electrode interconnection or wiring in contact with an insulating film at a portion thereof having a thinner thickness than at other portions and provided in semiconductor devices such as an MIS (Metal Insulator semiconductor) LSI, and a DRAM (Dynamic Random Access Memory).

### 2. Description of the Related Art

The miniaturization of semiconductor elements such as a MIS transistors in an LSI, for example, a memory device such as a DRAM, has led to a gradual thinning of the gate insulating film and capacitor dielectric film of silicon dioxide (SiO₂) therein.

During experiments by the present inventors, it was found that, when the thickness of the gate insulating film of a MIS transistor becomes less than 100Å, for example about 50Å (1 Å = 0,1 nm) a remarkable deviation and deterioration of the quality, such as a deviation of the threshold value, and deterioration of the gate breakdown voltage etc., occurs. Further it was found and recognized that, in a DRAM having a stacked type memory cell, when the thickness of a dielectric film forming a memory cell capacitor becomes thin, a short-circuit between the capacitor electrodes is apt to occur. Other semiconducteur devices are disclosed in US-A- 3897282.

### SUMMARY OF THE INVENTION

Accordingly, an object of the present invention is to prevent a deterioration of the quality of an element and an increase of the defect rate caused by miniaturization of the semiconductor elements. In particular, the object of the present invention is to prevent the deviation of quality, such as the deviation of the threshold value and deterioration of the gate breakdown voltage of the MIS transistor due to a thinning of the gate insulating film.

A further object of the present invention is to decrease the defect generation rate of the memory capacitor caused by the thinning of the capacitor dielectric film of the DRAM cell.

Therefore, according to the present invention, there is provided a semiconductor device comprising:
an insulating film having a first part and a second part, the second part having a thickness of less than 10 nm being thinner than the first part; and
a polycrystalline silicon (poly Si) film having a first part arranged over the first part of said insulating film and a second part arranged over the second part of said insulating film, the second part of said polycrystalline silicon film having a lower concentration of impurities than that of the first part of said polycrystalline silicon film.

### BRIEF DESCRIPTION OF THE DRAWINGS

Figure 1 is a cross-sectional view of a MIS transistor;
Fig. 2 is a graph of an impurity concentration in a poly Si gate, a SiO₂ gate insulating film, and a Si substrate;
Fig. 3 shows a cross-sectional view of a stacked type DRAM cell;
Fig. 4A is a graph of the relationship between the non-defective ratio and the impurity concentration in a poly Si electrode;
Fig. 4B is a graph of the relationship between non-defective ratio and capacitor dielectric film thickness when impurity concentration was changed;
Fig. 5 is a partial cross sectional view of Fig. 3 explaining step X;
Fig. 6A is a plan view of a first embodiment of a MIS semiconductor device according to the present invention;
Fig. 6B is a cross-sectional view taken along the line A-A of Fig. 6A;
Figs. 7A to 7D are cross-sectional views of the process of producing the structure shown in Figs. 6A and 6B;
Fig. 8A is a plan view of a second embodiment of MIS semiconductor device according to the present invention;
Fig. 8B is a cross sectional view taken along the line B-B of Fig. 8A;
Figs. 9A to 9C are cross sectional views of the process for producing the structure shown in Figs. 8A and 8B; and,
Fig. 10 is a cross-sectional view of a third embodiment of a stacked type DRAM cell according to the present invention.

### DESCRIPTION OF THE PREFERRED EMBODIMENTS

The preferred embodiments of the invention will now be explained.

The present inventors found, by experiment, that the aforementioned problems occur most when a gate electrode or a capacitor plate electrode is made of polycrystalline silicon, and that the thickness of an insulating film arranged below the poly Si film and the impurity concentration in the poly si film have a remarkable influence on the defect generation ratio.

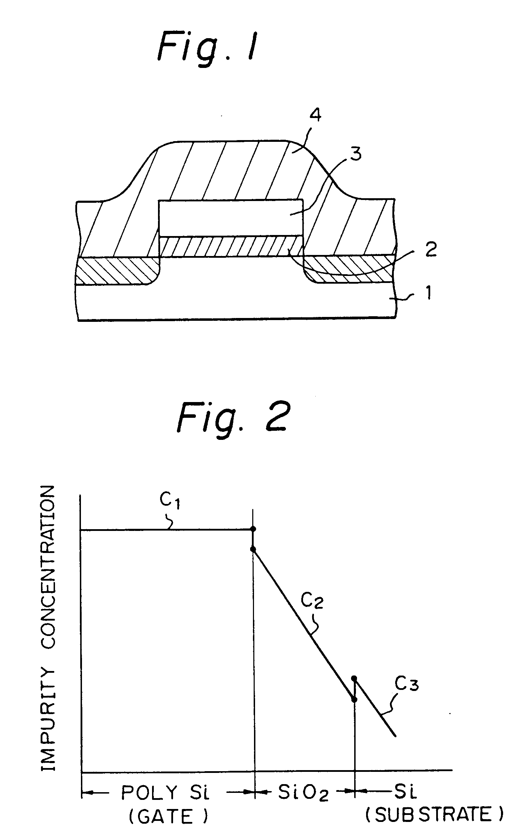

Due to this miniaturization of semiconductor elements, the lengths of interconnections or wiring are increased and the width thereof reduced, and thus although the interconnection resistance is enhanced, problems of delays in operation arise. Accordingly, when polycrystalline silicon is widely used as the material for, for example, a gate electrode as shown in Fig. 1, the interconnection resistance is lowered by an increased amount of impurities introduced into the poly Si gate electrode 3.

The increase of the impurity concentration in the poly Si, which is used for lowering the electric resistance, becomes the cause of a generation of defects in the MIS transistor or DRAM cell.

The relationship between the gate insulating film thickness and the impurity concentration in the MIS transistor will be explained with reference to Figures 1 and 2.

When the thickness of the gate insulating film 2, e.g., SiO₂, becomes less than 100 Å, for example, about 50 Å, a deviation of the threshold value and a deterioration of gate breakdown voltage are generated by a diffusion of impurities from an impurity introduced by a poly Si gate electrode 3 which is in contact with the gate insulating film 2 arranged on an Si substrate 1. In Fig. 1 4 denotes an insulating film such as PSG of SiO₂.

As shown in Fig. 2 illustrating an impurity concentration profile or distribution, impurities introduced into the electrode interconnection as shown in line C1, are self-diffused to some extent into the gate SiO₂ film as shown in line C₂ and into the silicon substrate through the SiO₂ film as shown in line C₃. The ordinate axis is shown in logarithmic scale.

The diffusion of the impurities into the gate SiO₂, etc., is effected by a heat treatment carried out after the formation of the gate electrode. As can be seen from Fig. 2 the insulating properties of the SiO₂ film are deteriorated as shown in the impurity diffusion line C₂, particularly near the Poly Si gate electrode. Further, the threshold voltage is varied by the impurity diffusion shown in line C₃, and the diffusion region of the SiO₂ film, etc., is varied, depending on the temperature, time and atmosphere of the heat treatment.

For example, it was found that, when the diffusion depth in the gate insulating film was about 20Å, which depth is 10% or less that of a conventionally used gate SiO₂ film thickness of about 200 to 300Å, the diffusion did not have a great influence on the quality, but as the miniaturization of is advanced, the above-mentioned diffusion depth has a high ration, e.g., about 40% of the gate SiO₂ film thickness and the diffusion has a serious influence on the transistor quality, such as deviation of the threshold value and deterioration of the gate breakdown voltage etc.

Figure 2 shows a graph of an impurity concentration in a poly Si gate (C₁), a SiO₂ gate insulating film (C₂), and a Si substrate (C₃), wherein the transverse axis shows the depth, and C₁, C₂, and C₃ are the impurity concentration distribution.

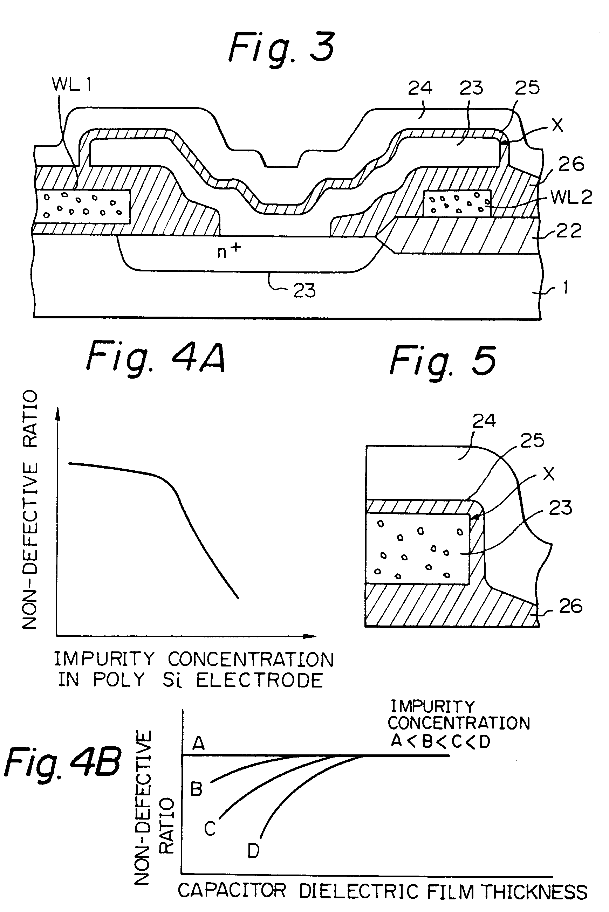

Further, in a DRAM cell shown in Fig. 3, when an insulating film such as SiO₂ 25 between a Poly Si charge storage electrode 23 and the other poly Si capacitor plate electrode 24 is thinned, impurities introduced into both poly Si electrodes, particularly, the electrode 24, are diffused into the insulating film 23. In Fig. 3, 1, 22 and 26 denote a p-Si substrate, a field SiO₂ film, and an insulating film, respectively. Therefore, when the impurity concentration of the poly Si electrodes becomes higher than a desired level, the non-defective ratio becomes lower, as shown in Fig. 4A.

On the other hand, from the viewpoint of the capacitance loss derived from the formation of a depletion layer, a higher impurity concentration reduces this capacitance loss.

Figure 4B is a graph of the relationship between non-defective ratio and capacitor dielectric film thickness when impurity concentration was changed.

As shown in Fig. 4B as the impurity concentration is increased the non-defective ratio is reduced.

The insulating film between the charge storage electrode and the capacitor plate electrode is broken down at the step X as shown in Fig. 3 by the stress concentration thereat, as shown particularly in Fig. 5. The stress concentration at the step X becomes larger as the edge form of the charge storage electrode 23 becomes sharper. But, round off the edge of the charge storage electrode is difficult. When a concentration of impurities introduced into the capacitor plate electrode becomes large, grains in the electrode become large, and thus mechanical and local stresses therein are enhanced, particularly near the edge of the charge storage electrode. In this DRAM, when the thickness of a capacitance forming insulating film is larger than about 130 Å the non-defective ratio is substantially 100%, but when the thickness thereof is less than about 60 Å, the non-defective ratio is lowered as the introduced impurity concentration is increased, particularly to more than 10²¹/cm³.

The present invention is derived from the above-explained findings of the inventors.

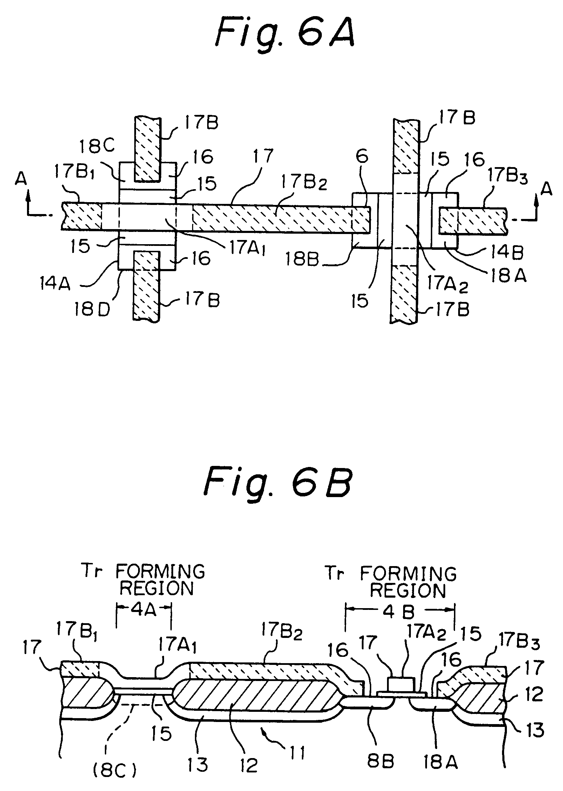

Figure 6A is a plan view of a first embodiment of a MIS semiconductor device according to the present invention, and Figure 6B is a cross-sectional view taken along the line A-A of Fig. 6A.

As shown in Figs. 6A and 6B the MIS semiconductor device has a first transistor forming region 14A and a second transistor forming region 14B, with a gate insulating film having a thin thickness of about 50 Å, and a polycrystalline silicon (Poly Si) pattern having n⁻ gate electrode portions 17A₁ and 17A₂ having a high sheet resistance of, for example, about 600 Ω/□ obtained by introducing a low concentration of impurities, e.g., phosphorus or arsenic, of about 10¹⁸ to 10²⁰ cm⁻³ thereto, and n⁺ interconnection portions 17B, 17B₁ , 17B₂ , and 17B₃ having a low sheet resistance of, for example about 25 Ω/□, obtained by introducing a high concentration impurities, e.g., phosphorus or arsenic, of about 10²⁰ to 10²² cm⁻³ thereto.

The interconnections 17, i.e., 17A₁ , 17A₂ , 17B, 17B₁ , 17B₂ and 17B₃ , are provided on a p⁻ Si substrate 11 and a field SiO₂ film 12 having a thick thickness, particularly as shown in Fig. 6B.

In Figs. 6A and 6B, a p-channel stopper region 13, gate SiO₂ films 15, contact windows 16, and n⁺ source/drain regions 18A to 18D are also provided.

Namely, in the MIS semiconductor device shown in Figs. 6A and 6B, the impurities introduced into the gate electrode portions 17A₁ and 17A₂ are limited to a low concentration level, and thus the diffusion of the impurities into a thin gate SiO₂ film 15 is also limited.

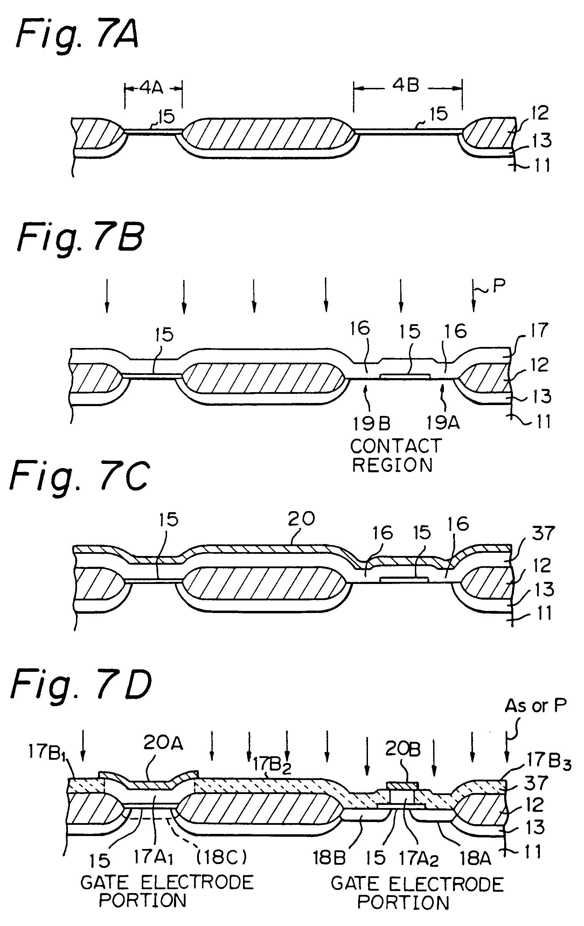

The MIS semiconductor device shown in Figs. 6A and 6B can be produced by the following steps, as shown in Figures 7A to 7D.

As shown in Fig. 7A, field SiO₂ films 12 having P channel stopper regions 13 therebelow are formed on a p⁻ Si substrate 11 by a usual method, so that first and second transistor forming regions are exposed, and then gate SiO₂ films 15 having a thickness of about 50 Å are formed on the first and second transistor forming regions 14A and 14B by a well known thermal oxidation process.

Then, as shown in Fig. 7B, a gate SiO₂ film 15 arranged on regions 19A and 19B, where a source/drain contact is effected, are selectively removed by a usual photolithography technique so that contact windows 16 are formed. Then a poly Si layer 17 having a thickness of about 4000 Å is formed on the substrate 11 by a CVD process and, for example, phosphorus (P) is introduced into the entire surface of the Poly Si layer 17, at a low concentration, by a usual gas diffusion process, whereby the phosphorus concentration of the Poly Si layer 17 is controlled to 10¹⁸ to 10²⁰ cm⁻³ and the sheet resistance is made an n⁻ type of about 600 Ω/□.

Then, as shown in Fig. 7C, a SiO₂ film 20 having a thickness of about 500 Å is formed on the poly Si layer 17 by the thermal oxidation and the poly Si layer 17 is patterned by a usual photolithography technique, so that an n⁻ poly Si pattern 37 is formed.

Then, as shown in Fig. 7D, the SiO₂ film 20 is patterned by a usual photolithography technique using the SiO₂ film 20 as a mask, and thus SiO₂ mask patterns 20A and 20B covering gate electrode portions 17A₁ , 17A₂ , etc., are formed on the n⁻ poly Si pattern 37. Then, using the SiO₂ mask patterns 20A and 20B, a high concentration of phosphorus or arsenic, e.g., 10¹⁹ to 10²¹/cm³, is selectively introduced into the exposed regions by a usual gas diffusion process, so that n⁺ interconnection or wiring forming portions 17B₁ , 17B₂ and 17B₃ and n⁺ source/drain regions 18A, 18B and 18C having a low sheet resistance of about 25 Ω/□ are formed. In this process, the n⁺ region, which is integral with the source/drain regions 18A, 18B, 18C, etc., can be formed on the surface of the substrate 11 positioned below the interconnection forming portions 17B₁ , 17B₂ , and 17B₃.

Then, as shown in Fig. 7D, the poly Si pattern 37 is separated to form a required shape by a usual photolithography technique, so that a MIS semiconductor device providing poly Si electrode interconnection or wiring 17 having low impurity concentration n⁻ gate electrode portions 17A₁ and 17A₂ with a high sheet resistance and high impurity concentration n⁺ interconnection or wiring portions 17B₁ , 17B₂ , 17B₃ with a low sheet resistance are produced.

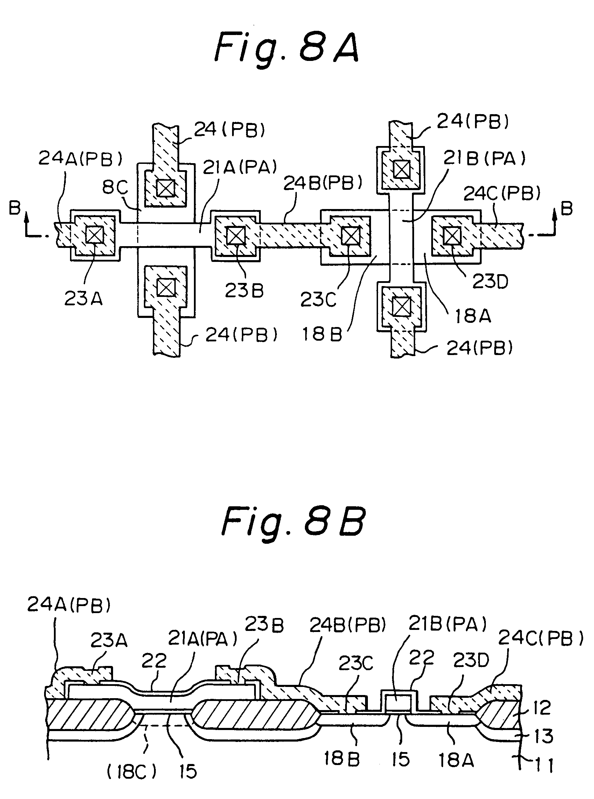

Figure 8A is a plan view of a second embodiment of a MIS semiconductor device having a poly Si electrode interconnection consisting of two poly Si layers according to the present invention, and Figure 8B is a cross-sectional view taken along the line B-B of Fig. 8A. As shown in Figs. 8A and 8B, n⁻ poly Si gate electrodes 21A and 21B corresponding to the gate electrode portions 17A₁ and 17A₂ of the first embodiment are formed by a first poly Si layer 21A (PA) and 21B (PA) (lower layer), and n⁺ poly Si interconnection portions 24, 24A, 24B, and 24C corresponding to interconnection portions 17B, 17B₁ , 17B₂ and 17B₃ are formed by a second poly Si layer (PB) (upper layer). The n⁻ poly Si gate electrode 21A is connected to the n⁺ poly Si interconnections 24 and 24B through contact windows formed in an insulating film, for example, a SiO₂ film 2. Further, the other end portion of the poly Si interconnection 24B is connected to an n⁺ source/drain region 18A of a MOS transistor formed in the region 4B (cf Fig. 6B) through a contact window 22 formed on the upper surface of the source/drain region.

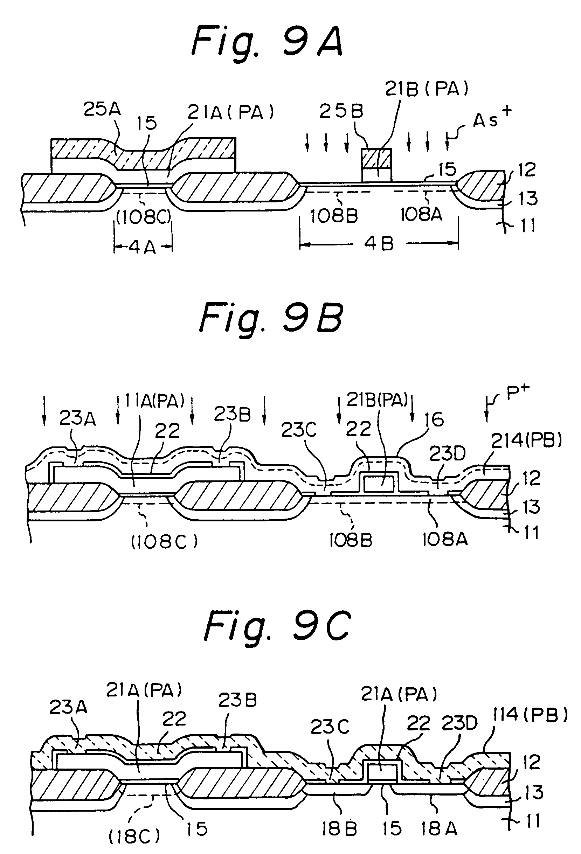

The structure shown in Figs. 8A and 8B can be produced by the process shown in Figs. 9A to 9C.

As shown in Fig. 9A, a gate SiO₂ film 15 having a thickness of about 50 Å is formed by a thermal oxidation process in the first and second transistor forming regions 14A and 14B defined by a field SiO₂ film 12 and p channel stopper region 13. Then, a first poly Si layer (PA) is formed on a p⁻ Si substrate, a low concentration of phosphorus, which is the same as in the first embodiment, is introduced into the first poly Si layer, n-poly Si gate electrodes 21A and 21B are formed by patterning the poly Si layer using resist patterns 25A and 25B as a mask, and subsequently, a high concentration of arsenic ions (As⁺) is implanted into the transistor forming regions 14A and 14B through the gate SiO₂ film 15 using the resist patterns 25A and 25B as a mask, whereby high concentration As⁺ implanted regions 108A, 108B and (108C), which become source/drain regions, are formed.

Then, as shown in Fig. 9B, after removing the resist patterns 25A and 25B and exposed gate SiO₂ film 15, a SiO₂ film 22 having a thickness of about 1000 Å is formed on the surface of the gate electrodes 21A and 21B and exposed substrate surface in the transistor forming regions 14A and 14B by a thermal oxidation process etc., and subsequently, contact windows 23A, 23B, 23C and 23D are formed in the SiO₂ film 22. Then, a second poly Si (PB) layer 214 having a thickness of about 5000 Å is formed on the substrate 11.

A high concentration of phosphorus ions (p⁺) is implanted into the second poly Si (PB) layer so that the high concentration p⁺ implanted region 26 is formed.

Then, as shown in Fig. 9C, by carrying out a heat treatment process p⁺ implanted ions at high concentration are activated and redistributed so that a second n⁺ poly Si layer (PB) 114 having low sheet resistance is formed, and at the same time, the high concentration As⁺ is activated and redistributed so that n⁺ source/drain regions 8A, 8B, and 18C are formed.

Then, as shown in Figs. 8A and 8B, the second n⁺ poly Si layer (PB) 114 is patterned by a usual photolithography technique and an n⁺ poly Si interconnection 24A, which is connected to an end portion of the gate electrode 21A, an n⁺ poly Si interconnection 24B, which is in contact with the other end portion of the gate electrode 21A, and the source/drain region 18B through the contact windows 23B and 23C, and the n⁺ poly Si interconnection layer 24C, which is connected to the source/drain region 18A through the contact window 23D, are formed, respectively, whereby the second embodiment of the MIS semiconductor device is realized.

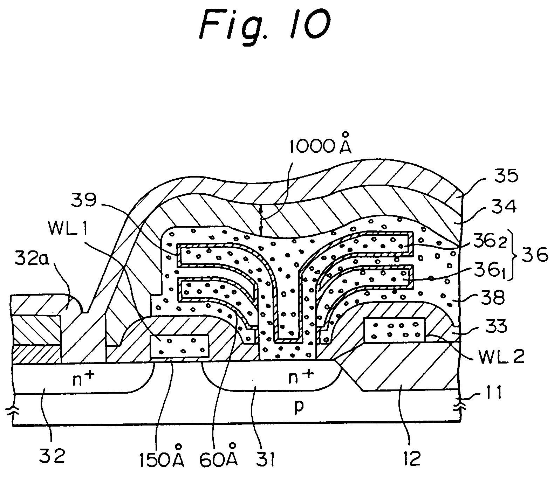

The third embodiment in which the present invention was applied of to a stacked type DRAM cell will be explained with reference to Figure 10.

Figure 10 is a cross-sectional view of a DRAM cell according to the present invention.

When the impurity concentration of the poly Si capacitor plate electrode 25 in the DRAM cell shown in Fig. 3 decreases the defect ration can be remarkably lowered. Particularly, in the DRAM cell shown in Fig. 10, the area of the charge storage electrode 36 and the capacitor plate electrode 38 having the dielectric film 39 therebetween is large, and thus the effect of the present invention is remarkable.

In Fig. 10 a field SiO₂ film 12, As⁺ implanted diffusion layers (source/drain) 32 and 31, and gate electrodes WL1 and WL2 of poly Si are provided on a p-Si substrate 11. The extensions of the WL1 and WL2 are word lines in the DRAM, and a bit line (not shown) is connected to the source 32. The layer insulating the gate electrodes WL1 and WL2 is an insulating film 33 such as a Si₃N₄ film. Thus a transfer transistor is formed. Reference 37 (31₁ , 36₂) denotes a poly Si charge storage electrode, and 38 denotes the Poly Si capacitor plate electrode.

The poly Si charge storage electrode and the poly Si capacitor plate electrode and the dielectric film 39 therebetween, form a charge storage capacitor.

In a gate electrode WL1, impurities for example, phosphorus having a concentration of 10²⁰ to 10²¹/cm³ are introduced thereto. The thickness of the insulating layer below the gate electrode WL1 is about 150 Å. On the other hand, in the poly Si electrode 36, impurities, for example, phosphorus, having a concentration of 10¹⁹ to 10²⁰/cm³ are introduced thereto. The thickness of the dielectric film 39 is about 60 Å, and a PSG layer 34 covering the electrode 36 has a thickness of 1000 Å. References 32a and 35 denote drawing electrodes and wiring. The concentration of impurities (arsenic) of the bit line if about 10²¹/cm³. The thickness of the SiO₂ film with which the bit line is in contact is about 1000Å. According to the present invention preferably the impurity concentration in poly Si stacked on a insulating film having a minimum thickness is lower than the impurity concentration in other portions.

As explained above, according to the present invention, the (gate) insulating film can be formed so that is has very thin thickness, since impurities introduced into the electrode interconnection or wiring are controlled to a low level.

## Claims

1. A semiconductor device comprising :
an insulating film structure having a first part (12; 26; 34) and a second part (25; 39), the second part having a thickness of less than 10 nm being thinner than the first part; and
a polycrystalline silicon film having a first part (WL1, WL2; 35) arranged over the first part of said insulating film and a second part (38) arranged over the second part of said insulating film, the second part of said polycrystalline silicon film having a lower concentration of impurities than that of the first part of said polycrystalline silicon film.

2. A semiconductor device according to claim 1, wherein said device comprises a MIS transistor having a gate electrode (17) composed of the second part of said polycrystalline silicon film, a gate insulator (15) composed of the second part of said insulating film, a field insulator (12) composed of the first part of said insulating film, and a wiring (17B₁, 17B₂) composed of a doped portion of the first part of said insulating film and connected to the gate electrode.

3. A semiconductor device according to claim 2, wherein the first and second parts (respectively 26, 25) of said insulating film structure are arranged in a single layer.

4. A semiconductor device according to claim 2, wherein the first and second parts (respectively 12; 35 and 25; 39) of said insulating film structure are arranged in different layers.

5. A semiconductor device according to claim 1, wherein the second part (25) of said insulating film structure is comprised of the part of said insulating film having the minimum thickness.

6. A semiconductor device according to claim 1, wherein said device comprises a dynamic type memory cell including a cell capacitor composed of a charge storage electrode (23) arranged underneath the second part of said insulating film, and capacitor dielectric film (25) composed of the second part of said insulating film structure, a capacitor plate electrode (24) composed of the second part of said polycrystalline silicon film.

7. A semiconductor device according to any one of claims 1 to 6, wherein the concentration of impurities in the second part of said polycrystalline silicon film (38) is 10¹⁸/cm³ to 10²⁰/cm³, and the concentration of impurities in the first part of the polycrystalline silicon film (WL1, WL2; 35) is 10¹⁹/cm³ to 10²¹/cm³.

8. A semiconductor device according to any one of claims 1 to 7, wherein a thickness of the first part of said insulating film is more than 100nm.

9. A semiconductor device according to claim 1, wherein said device comprises : a DRAM cell comprising a transfer transistor, a capacitor, a bit line (35) formed on an inter-layer insulation film (34) and connected to a source region (32) of the transfer transistor and a word line (WL2) formed on a field insulation film (12) and connected to a gate electrode of the transfer transistor, the capacitor comprising a charge storage electrode (36) connected to a drain region (31) of the transfer transistor, a capacitor dielectric film (39) covering the charge storage electrode and a counter electrode (38), said capacitor dielectric film (39) forming the second part of said insulating film structure, said counter electrode (38) forming the second part of said polycrystalline silicon film, said field insulation film (12) forming the first part of said insulating film structure and said word line (WL2) forming the first part of said polycrystalline Si film.

10. A semiconductor device according to claim 1, wherein said device comprises: a DRAM cell comprising a transfer transistor, a capacitor, a bit line (35) formed on an inter-layer insulation film (34) and connected to a source region (32) of the transfer transistor and a word line (WL2) formed on a field insulation film (12) and connected to a gate electrode of the transfer transistor, a capacitor dielectric film (39) covering the charge storage electrode and a counter electrode (38), said capacitor dielectric film (39) forming the second part of said insulating film structure, said counter electrode (38) forming the second part of said polycrystalline silicon film, said inter-layer insulating film (34) forming the first part of said insulating film structure and said bit line (35) forming the first part of said polycrystalline Si film.

## Patentansprüche

1. Halbleitervorrichtung, die folgendes aufweist:
eine Isolierschichtstruktur mit einem ersten Teil (12; 26; 34) und einem zweiten Teil (25; 39), wobei der zweite Teil eine Dicke von weniger als 10 nm aufweist und dünner ist als der erste Teil; und
eine Schicht aus polykristallinem Silizium mit einem ersten Teil (WL1, WL2; 35), der über dem ersten Teil der Isolierschicht angeordnet ist, und mit einem zweiten Teil (38), der über dem zweiten Teil der Isolierschicht angeordnet ist, wobei der zweite Teil der Schicht aus polykristallinem Silizium eine niedrigere Fremdstoffkonzentration als der erste Teil der Schicht aus polykristallinem Silizium besitzt.

2. Halbleitervorrichtung nach Anspruch 1,
wobei die Vorrichtung einen Metall-Isolator-Halbleiter-Transistor aufweist, der eine aus dem zweiten Teil der Schicht aus polykristallinem Silizium gebildete Gateelektrode (17), einen aus dem zweiten Teil der Isolierschicht gebildeten Gate-Isolator (15), einen aus dem ersten Teil der Isolierschicht gebildeten Feld-Isolator (12) sowie eine Verdrahtung (17B₁, 17B₂) aufweist, die aus einem dotierten Bereich des ersten Teils der Isolierschicht gebildet ist und mit der Gateelektrode verbunden ist.

3. Halbleitervorrichtung nach Anspruch 2,
wobei der erste und der zweite Teil (26 bzw. 25) der Isolierschichtstruktur in einer einzigen Schicht angeordnet sind.

4. Halbleitervorrichtung nach Anspruch 2,
wobei der erste und der zweite Teil (12; 35 bzw. 25; 39) der Isolierschichtstruktur in verschiedenen Schichten angeordnet sind.

5. Halbleitervorrichtung nach Anspruch 1,
wobei der zweite Teil (25) der Isolierschichtstruktur aus demjenigen Teil der Isolierschicht gebildet ist, der die geringste Dicke besitzt.

6. Halbleitervorrichtung nach Anspruch 1,
wobei die Vorrichtung eine dynamische Speicherzelle umfaßt, die einen Zellenkondensator, der aus einer unter dem zweiten Teil der Isolierschicht angeordneten Ladungsspeicherelektrode (23) gebildet ist, eine Kondensator-Dielektrikumschicht (25), die aus dem zweiten Teil der Isolierschichtstruktur gebildet ist, sowie eine Kondensatorplattenelektrode (24) aufweist, die aus dem zweiten Teil der Schicht aus polykristallinem Polysilizium gebildet ist.

7. Halbleitervorrichtung nach einem der Ansprüche 1 bis 6,
wobei die Fremdstoffkonzentration in dem zweiten Teil der Schicht aus polykristallinem Silizium (38) 10¹⁸/cm³ bis 10²⁰/cm³ beträgt und die Fremdstoffkonzentration in dem ersten Teil der Schicht aus polykristallinem Silizium (WL1, WL2; 35) 10¹⁹/cm³ bis 10²¹/cm³ beträgt.

8. Halbleitervorrichtung nach einem der Ansprüche 1 bis 7,
wobei die Dicke des ersten Teils der Isolierschicht mehr als 100 nm beträgt.

9. Halbleitervorrichtung nach Anspruch 1,
wobei die Vorrichtung folgendes aufweist:
eine DRAM-Zelle mit einem Transfertransistor, einem Kondensator, einer Bitleitung (35), die auf einer Zwischenlagen-Isolierschicht (34) ausgebildet ist und mit einem Sourcebereich (32) des Transfertransistors verbunden ist, und mit einer Wortleitung (WL2), die auf einer Feldisolierschicht (12) ausgebildet ist und mit einer Gate-elektrode des Transfertransistors verbunden ist, wobei der Kondensator eine mit einem Drainbereich (31) des Transfertransistors verbundene Ladungsspeicherelektrode (36), eine die Ladungsspeicherelektrode bedeckende Kondensator-Dielektrikumschicht (39) und eine Gegenelektrode (38) aufweist, wobei die Kondensator-Dielektrikumschicht (39) den zweiten Teil der Isolierschichtstruktur bildet, die Gegenelektrode (38) den zweiten Teil der Schicht aus polykristallinem Silizium bildet, die Feldisolierschicht (12) den ersten Teil der Isolierschichtstruktur bildet und die Wortleitung (WL2) den ersten Teil der Schicht aus polykristallinem Silizium bildet.

10. Halbleitervorrichtung nach Anspruch 1,
wobei die Vorrichtung folgendes aufweist:
eine DRAM-Zelle mit einem Transfertransistor, einem Kondensator, einer Bitleitung (35), die auf einer Zwischenlagen-Isolierschicht (34) ausgebildet ist und mit einem Sourcebereich (32) des Transfertransistors verbunden ist, und mit einer Wortleitung (WL2), die auf einer Feldisolierschicht (12) ausgebildet ist und mit einer Gate-elektrode des Transfertransistors verbunden ist, wobei eine Kondensator-Dielektrikumschicht (39) die Ladungsspeicherelektrode bedeckt, und mit einer Gegenelektrode (38), wobei die Kondensator-Dielektrikumschicht (39) den zweiten Teil der Isolierschichtstruktur bildet, die Gegenelektrode (38) den zweiten Teil der Schicht aus polykristallinem Silizium bildet, die Zwischenlagen-Isolierschicht (34) den ersten Teil der Isolierschichtstruktur bildet und die Bitleitung (35) den ersten Teil der Schicht aus polykristallinem Silizium bildet.

## Revendications

1. Dispositif à semiconducteur comprenant :
une structure de pellicule isolante possédant une première partie (12; 26; 34) et une deuxième partie (25; 39), la deuxième partie, d'épaisseur inférieure à 10 nm, étant plus mince que la première partie ; et
une pellicule de silicium polycristallin possédant une première partie (WL1, WL2; 35) disposée sur la première partie de ladite pellicule isolante et une deuxième partie (38) disposée sur la deuxième partie de ladite pellicule isolante, ladite deuxième partie de ladite pellicule de silicium polycristallin présentant une concentration en impuretés qui est inférieure à celle de la première partie de ladite pellicule de silicium polycristallin.

2. Dispositif à semiconducteur selon la revendication 1, où ledit dispositif comprend un transistor MIS qui possède une électrode de grille (17) composée de la deuxième partie de ladite pellicule de silicium polycristallin, un isolant de grille (15) composé de la deuxième partie de ladite pellicule isolante, un isolant de champ (12) composé de la première partie de ladite pellicule isolante, et un câblage (17B₁, 17B₂) composé par une partie dopée de la première partie de ladite pellicule isolante et connecté à l'électrode de grille.

3. Dispositif à semiconducteur selon la revendication 2, où les première et deuxième parties (respectivement 26, 25) de ladite structure de pellicule isolante sont disposées en une couche unique.

4. Dispositif à semiconducteur selon la revendication 2, où les première et deuxième parties (respectivement 12; 35 et 25; 39) de ladite structure de pellicule isolante sont disposées en différentes couches.

5. Dispositif à semiconducteur selon la revendication 1, où la deuxième partie (25) de ladite structure de pellicule isolante est constituée de la partie de ladite pellicule isolante qui possède l'épaisseur minimale.

6. Dispositif à semiconducteur selon la revendication 1, où ledit dispositif comprend une cellule de mémoire de type dynamique comportant un condensateur de cellule composé d'une électrode d'emmagasinage de charge (23) placée au-dessous de la deuxième partie de ladite pellicule isolante, et une pellicule diélectrique de condensateur (25) constituée de la deuxième partie de ladite structure de pellicule isolante, ainsi qu'une électrode formant une plaque de condensateur (24) constituée de la deuxième partie de ladite pellicule de silicium polycristallin.

7. Dispositif à semiconducteur selon l'une quelconque des revendications 1 à 6, où la concentration en impuretés de la deuxième partie de ladite pellicule de silicium polycristallin (38) est de 10¹⁸ cm⁻³ à 10²⁰ cm⁻³, et la concentration en impuretés de la première partie de la pellicule de silicium polycristallin (WL1, WL2; 35) est de 10¹⁹ cm⁻³ à 10²¹ cm⁻³.

8. Dispositif à semiconducteur selon l'une quelconque des revendications 1 à 7, où l'épaisseur de la première partie de ladite pellicule isolante est supérieure à 100nm.

9. Dispositif à semiconducteur selon la revendication 1, où ledit dispositif comprend : une cellule de DRAM comprenant un transistor de transfert, un condensateur, une ligne de bit (35) formée sur une pellicule d'isolation intercouches (34) et connectée à une région de source (32) du transistor de transfert, et une ligne de mot (WL2) formée sur une pellicule d'isolation de champ (12) et connectée à une électrode de grille du transistor de transfert, le condensateur comprenant une électrode d'emmagasinage de charge (36) connectée à une région de drain (31) du transistor de transfert, une pellicule diélectrique de condensateur (39) couvrant l'électrode d'emmagasinage de charge, et une contre-électrode (38), ladite pellicule diélectrique de condensateur (39) formant la deuxième partie de ladite structure de pellicule isolante, ladite contre-électrode (38) formant la deuxième partie de ladite pellicule de silicium polycristallin, ladite pellicule d'isolation de champ (12) formant la première partie de ladite structure de pellicule isolante, et ladite ligne de mot (WL2) formant la première partie de ladite pellicule de silicium polycristallin.

10. Dispositif à semiconducteur selon la revendication 1, où ledit dispositif comprend : une cellule de DRAM comprenant un transistor de transfert, un condensateur, une ligne de bit (35) formée sur une pellicule d'isolation intercouches (34) et connectée à une région de source (32) du transistor de transfert, et une ligne de mot (WL2) formée sur une pellicule d'isolation de champ (12) et connectée à une électrode de grille du transistor de transfert, une pellicule diélectrique de condensateur (39) couvrant l'électrode d'emmagasinage de charge, et une contre-électrode (38), ladite pellicule diélectrique de condensateur (39) formant la deuxième partie de ladite structure de pellicule isolante, ladite contre-électrode (38) formant la deuxième partie de ladite pellicule de silicium polycristallin, ladite pellicule d'isolation inter-couches (34) formant la première partie de ladite structure de pellicule isolante, et ladite ligne de bit (35) formant la première partie de ladite pellicule de silicium polycristallin.
